(19) **Europäisches Patentamt**

**European Patent Office**

**Office européen des brevets**

(11) Veröffentlichungsnummer: **0 272 447 B1**

(12) # EUROPÄISCHE PATENTSCHRIFT

(45) Veröffentlichungstag der Patentschrift: **16.09.92**

(21) Anmeldenummer: **87116871.2**

(22) Anmeldetag: **16.11.87**

(51) Int. Cl.⁵: **C23C 14/34**, F16C 33/14, F16C 33/12

(54) **Verbundwerkstoff mit einer durch Kathodenzerstäubung aufgebrachten Gleitschicht.**

(30) Priorität: **23.12.86 CH 5157/86**

(43) Veröffentlichungstag der Anmeldung:
**29.06.88 Patentblatt 88/26**

(45) Bekanntmachung des Hinweises auf die
Patenterteilung:
**16.09.92 Patentblatt 92/38**

(84) Benannte Vertragsstaaten:
**AT CH DE ES FR GB IT LI SE**

(56) Entgegenhaltungen:
**DE-A- 3 629 451**
**FR-A- 2 104 069**
**FR-A- 2 207 193**
**FR-A- 2 443 926**

(73) Patentinhaber: **BALZERS AKTIENGESELL-SCHAFT**

**FL-9496 Balzers(LI)**

(72) Erfinder: **Bergmann, Erich, Dr.**
**Sarganserstrasse 58**
**CH-8887 Mels(CH)**
Erfinder: **Braus, Jürgen, Dipl.-Ing.**
**Johann Jakob Astor Strasse 53**
**W-6909 Walldorf(DE)**

(74) Vertreter: **Troesch, Jacques J., Dr. sc. nat. et al**
**Troesch Scheidegger Werner AG Siewerdtstrasse 95**
**CH-8050 Zürich(CH)**

EP 0 272 447 B1

**Beschreibung**

Die Erfindung bezieht sich auf einen Verbundwerkstoff mit mindestens einer durch Kathodenzerstäubung aufgebrachten Gleitschicht, welche aus einem Gemisch von in statistischer Verteilung aufgestäubten Teilchen aus mindestens einem eine fest zusammengefügte Matrix bildenden metallischen Werkstoff und mindestens einem weiteren, in festem Zustand im Matrixwerkstoff praktisch unlöslichen metallischen Werkstoff besteht. Sie bezieht sich ferner auf ein Verfahren zur Herstellung derartiger Verbundwerkstoffe sowie eine Verwendung derselben in Gleitlagerschalen.

Gleitschichten als Oberflächenschichten von Verbundwerkstoffen finden beispielsweise Anwendung für Lagerschalen von Verbrennungsmotoren und müssen neben anderen folgende Eigenschaften aufweisen: geringere Härte als das Material der Welle, hohe Festigkeit gegenüber dynamischer Wechselbeanspruchung, hohen Scherwiderstand, Wärmestabilität der mechanischen Eigenschaften sowie hohe Korrosionsfestigkeit. Diese Anforderungen erfüllen unter anderem Zusammensetzungen aus Blei oder Zinn mit Metallen, die der Schicht durch Bildung einer zusammenhängenden Matrix mechanische Festigkeit verleihen, selbst korrosionsfest sind und keine Löslichkeit für Zinn oder Blei aufweisen, wie beispielsweise Aluminium, Chrom oder Nickel. Derartige Verbundwerkstoffe mit blei- oder zinnhaltigen Gleitschichten sowie Verfahren zu deren Herstellung mittels Kathodenzerstäubung sind in den DE-PS 28 53 724 und 29 14 618 sowie in der DE-OS 34 04 880 beschrieben.

Bei der Anwendung derartiger Gleitschichten als Oberflächenschichten werden an die betreffenden Form- oder Maschinenteile häufig sehr gegensätzliche Anforderungen gestellt.

Bei der Anwendung in Gleitlagern sollen diese auf der einen Seite zumindest an bestimmten Stellen die auf das Lager einwirkenden Kräfte mit ausreichender Lebensdauer auf die Umgebungskonstruktion übertragen (Tragfähigkeit), um die Flächenpressungen der Pleuel ertragen zu können. Dies erfordert eine verhältnismässig hohe warmbeständige Härte der betreffenden Gleitschichten, wobei 70 HV 0.002 erfahrungsgemäss einen kritischen Wert verkörpert, der nicht unterschritten werden darf. Auf der anderen Seite wird von anderen Stellen desselben Maschinenteils bzw. von dessen Gleitschicht ein gutes Einbettverhalten verlangt, worunter die Fähigkeit zu verstehen ist, Schmutz oder Verschleissteilchen in die Oberfläche einzulagern. Durch eine derartige Eigenschaft kann die Gefahr einer Beschädigung der Gleitflächen gemildert werden. Um dieser Anforderung zu genügen, sollten die Gleitschichten nicht zu hart sein. Erfahrungsgemäss bildet auch in diesem Zusammenhang eine Härte von 70 HV 0.002 einen kritischen Wert , welcher bereits verhältnismässig aufwendige Massnahmen erfordert, um das betreffende Lager vor Schmutzzutritt zu schützen und den Schmierstoff durch Filterung sauber zu halten.

Mit den im Stand der Technik beschriebenen, durch Kathodenzerstäubung aufgebrachten Gleitschichten sind derart widersprüchliche Anforderungen an ein und dasselbe Maschinen-oder Formteil nicht zu erfüllen, da die fraglichen Gleitschichten auf ihrer ganzen Oberfläche die gleichen Eigenschaften aufweisen.

Die Aufgabe der vorliegenden Erfindung besteht dementsprechend darin, Verbundwerkstoffe mit durch Kathodenzerstäubung aufgebrachten Gleitschichten zu schaffen, welche für unterschiedliche Stellen des gleichen Maschinen- oder Formteils völlig gegensätzliche werkstoffmässige Anforderungen erfüllen können, insbesondere gutes Einbettverhalten an einzelnen Stellen mit guter Tragfähigkeit an anderen Stellen kombinieren zu können.

Die Aufgabe wird durch einen Verbundwerkstoff nach dem Gattungsbegriff gelöst, welcher folgende Merkmale aufweist:

(a) Der Durchmesser der Partikel aus dem in der Matrix unlöslichen Werkstoff weist an vorbestimmten Stellen Gradienten auf,

(b) welche parallel zur Oberfläche der Gleitschicht verlaufen.

(c) Diesen Gradienten des Partikeldurchmessers entsprechen Gradienten der Härte der betreffenden Gleitschicht.

Der Erfindung liegt die Erkenntnis zugrunde, dass die Härte einer Gleitschicht von der Grösse der Partikel aus dem in der Matrix unlöslichen Werkstoff in dem Sinne abhängt, dass einem geringen Partikeldurchmesser hohe Härte und einem grösseren Partikeldurchmesser eine niedrigere Härte entspricht. Sucht man deshalb eine Gleitschicht, welche an bestimmten Stellen eine hohe Härte und dementsprechend gute Tragfähigkeit, an anderen Stellen eine geringere Härte entsprechend einer guten Einbettfähigkeit aufweist, so muss die Partikelgrösse des in der Matrix unlöslichen Werkstoffes entsprechend variiert werden, was durch Erzeugen entsprechender, parallel zur Oberfläche der Gleitschicht verlaufender Gradienten dieser Partikelgröse bewirkt werden kann. Für die erwähnten Werkstoffkombinationen (Matrix: Al, Cr, Ni, Unlösliches: Sn, Pb) erweist es sich dabei als vorteilhaft, wenn der Mittelwert der statistischen Normalverteilung des Durchmessers der unlöslichen Partikel im Bereich des Gradienten zwischen 0.05 $\mu$m und 10 $\mu$m variiert. An denjenigen Stellen der Gleitschicht, an denen höchste Tragfähigkeit und dementsprechend höchste Härte verlangt wird, weist der Durchmesser der Partikel aus dem unlöslichen Werkstoff dabei vorteilhafterweise eine statistische Normalverteilung mit einem Mittelwert von $\bar{x} < 0.8$ $\mu$m, vorzugsweise in einem Bereich zwischen 0.05 $\mu$m $< \bar{x} < 0.4$ $\mu$m auf. Dies entspricht einer rund zehnmal feineren Verteilung der den unlöslichen Werkstoff enthaltenden Partikel an den Stellen grösster Tragfähigkeit gegenüber den im Stand der Technik offenbarten Schichten. Weist etwa stranggegossenes AlSn2oCu eine Härte von 35 HV 0.01 auf, so erreichen die erfindungsgemässen Schichten an diesen härtesten Stellen eine Härte von mindestens 180 HV 0.002 (vgl.DE-PS 28 53 724, Spalte 6).

Im einzelnen kann die Erfindung derart ausgestaltet werden, dass als in der Matrix unlösliche Komponente mindestens eines der verhältnismässig niedrig schmelzenden Elemente Zinn (Smp. 231.89 °C), Blei (Smp. 327.4 °C) oder Indium (Smp. 156.4 °C) eingesetzt wird. Für Sonderanwendungen sind aber auch weitere niedrigschmelzende Metalle und ihre Legierungen nicht ausgeschlossen: Cadmium (Smp. 320.9 °C), Wismut (Smp. 271.3 °C), Thallium (Smp. 302 °C), Zink (Smp. 419.5 °C) und sogar Gallium (Smp. 29.8 °C). Die Erfindung weist besondere Vorteile für Verbundwerkstoffe auf, bei denen die matrixbildende Komponente eine herkömmliche Gleitlagerlegierung enthält, deren Hauptbestandteil eines der folgenden Elemente ist: Aluminium, Chrom, Nickel, Magnesium, Kupfer. Dabei hat es sich als besonders zweckmässig erwiesen, wenn die Gleitschicht als Ganzes eine Zusammensetzung mit einer der folgenden Kombinationen aufweist: AlCuSn, Al-CuPb, AlCuSnPb, AlSiSn, AlSiPb, AlSiSnPb, CuSn, CuPb, CuSnPb. Erfindungsgemässe Gleitschichten weisen vorzugsweise Schichtdicken zwischen 10 und 30 $\mu$m auf, wobei die untere Hälfte dieses Bereichs (12 bis 16 $\mu$m) für die meisten Anwendungen ausreicht. Die im Stand der Technik vorgeschlagene optimale Schichtdicke konventioneller Zweikomponentengleitschichten von 18 $\mu$m konnte insofern nicht bestätigt werden (vgl. U. ENGEL, in: SAE Technical Paper Series, International Congress and Exposition, Detroit 1986, Seite 76).

Aus den Stand der Technik (DE-PS 29 14 618, Spalte 5, DE-PS 28 53 724, Spalte 5) ist weiter bekannt, dass Oxidkonzentrationen zwischen 0.1 und 0.5 Volumenprozent zu einer sog. Dispersionsverfestigung der betreffenden Gleitschichten führen. Demgegenüber hat sich überraschenderweise gezeigt, dass erfindungsgemässe Schichten, bei deren Herstellung durch geeignete Massnahmen (Verwendung von in Inertgasatmosphäre hergestellter Targets) die Sauerstoffkonzentration auf weniger als 0.2 Gewichtsprozente gesenkt wurde, an den Stellen mit kleinstem Partikeldurchmesser der unlöslichen Komponente wesentlich verbesserte mechanische Eigenschaften gegenüber den bekannten dispersionsverfestigten Gleitschichten aufweisen. Die rund zehnmal feinere Verteilung dieser Partikel in der Matrix der Gleitschicht ersetzt damit die Verfestigung durch dispergierte Oxidteilchen bis zu einem gewissen Grade.

Auf der anderen Seite wurde überraschenderweise gefunden, dass die erfindungsgemässen Gleitschichten im Gegensatz zu den im Stand der Technik offenbarten Schichten auch durch eine Kombination dieser rund zehnmal feineren Verteilung der unlöslichen Komponente mit einer bis zu fünfmal höheren Sauerstoffkonzentration in der gesamten Gleitschicht eine wesentlich gesteigerte Anlassbeständigkeit erhalten. Währrend eine Wärmebehandlung von 300 Stunden bei 170 °C bei konventionellen Gleitschichten zu einer erheblichen Verminderung der Härte führt (vgl. DE-PS 28 53 724), so sinkt die Härte an diesen Stellen der erfindungsgemässen Schichten bei einer derartigen Wärmebehandlung nicht in nennenswertem Umfange. Durch eine derartige Kombination erreichen die betreffenden Stellen der Gleitschicht mit einer rund zehnmal feineren Verteilung der unlöslichen Komponente und mit der 2.5-fachen Sauerstoffkonzentration eine Härte von 100 HV 0.002.

Daneben zeigen diese Stellen der erfindungsgemässen Schichten gegenüber den im Stand der Technik offenbarten eine gesteigerte Anlassbeständigkeit.

Durch diese hohen Sauerstoffkonzentrationen in der Schicht wird eine weitgehende Einhüllung der feinverteilten unlöslichen Partikel durch O-Atome erreicht und diese vermindern die Gefahr, dass diese feinverteilten Partikel durch Kornumwandlung wiederum zu grösseren Partikeln reaggregieren und dadurch die vorteilhaften Eigenschaften der erfindungsgemässen Gleitschichten durch Alterung teilweise verlorengehen. Die Verhältnisse im Zeitpunkt der Erzeugung der Gleitschicht werden mit anderen Worten durch derart hohe Sauerstoffkonzentrationen im Zeitablauf stabilisiert. Auf diesem Zusammenhang beruht die gegenüber konventionellen sauerstoffdotierten Schichten wesentlich gesteigerte Festigkeit der erfindungsgemässen Gleitschichten gegenüber dynamischer Wechselbeanspruchung sowie die gesteigerte Wärmebeständigkeit der mechanischen Eigenschaften dieser Schichten. Dabei ist zu berücksichtigen, dass zur wirksamen Einhüllung sehr fein verteilter Partikel mit entsprechend grosser Gesamtoberfläche mehr Sauerstoffatome erforderlich sind als zur Einhüllung der gleichen Masse mit gröberer Verteilung und entsprechend kleinerer Gesamtoberfläche.

Entsprechend der spezifischen Funktion des zu beschichtenden Formteils können die Härtegradienten und damit die Stellen unterschiedlicher Härte der erfindungsgemässen Gleitschicht in an sich beliebiger geometrischer Konfiguration über die gesamte Fläche der Gleitschicht verteilt werden. In vielen Anwendungsfällen werden kreisringförmige Zonen höchster Härte benötigt, welche entsprechende Härtegradienten mit kreisringförmigem Grundriss erfordern, bei denen die Stellen grösster Härte im Innern des Kreisringes liegen.

Die Erfindung betrifft im weiteren ein Verfahren zum Herstellen der vorgeschlagenen Verbundwerkstoffe, bei denen die Gleitschicht durch das Verfahren der Kathodenzerstäubung (Sputtering) aufgebracht wird. Die Aufgabe bei diesem Teil der Erfindung bestand dabei darin, Gradienten des Durchmessers der unlöslichen Partikel in der Gleitschicht und damit Gradienten der Härte derselben in möglichst guter Reproduzierbarkeit, in beliebigen geometrischen Konfigurationen und innerhalb eines möglichst grossen Bereiches der Variation von Partikeldurchmesser bzw. Oberflächenhärte zu erzeugen.

Diese Aufgabe wird erfindungsgemäss dadurch gelöst, dass während dem Kathodenzerstäubungsvorgang im zu beschichtenden Substrat und in der entstehenden Gleitschicht selbst Temperaturgradienten erzeugt und aufrechterhalten werden, welche parallel zur Oberfläche des Substrats verlaufen. Derartige Temperaturgradienten können vorteilhafterweise dadurch erzeugt werden, dass das zu beschichtende Substrat während dem Kathodenzerstäubungsvorgang an unterschiedlichen Stellen unterschiedlich stark gekühlt wird, wobei die grösste Kühlleistung an denjenigen Stellen erbracht wird, an denen die Gleitschicht kleinsten Partikeldruchmesser und grösste Härte aufweisen soll. Die Temperatur des zu beschichtenden Substrats und aufwachsenden Gleitschicht wird dabei vorteilhafterweise in einem Bereich zwischen -10 und 190 °C gehalten, diejenige der Stellen, an denen kleinster Partikeldurchmesser und grösste Härte der Gleitschicht angestrebt wird, zwischen -10 und +70 °C. Diesem Vorgehen liegt die überraschende Erkenntnis zugrunde, dass eine Verminderung der Substrattemperatur beim Kathodenzerstäuben zu einer unerwartet grossen Verminderung des mittleren Durchmessers der in der Matrix unlöslichen Partikel und damit zu einer entsprechenden Steigerung der Härte der Gleitschicht an den betreffenden Stellen führt, welche mit höherer Wechselfestigkeit und Korrosionsbeständigkeit einhergeht.

Neben dieser Reduktion der Beschichtungstemperatur trägt auch eine gegenüber dem Stand der Technik erhöhte Beschichtungsgeschwindigkeit über 0.2 µm/Minute zu er erfindungsgemässen Feinverteilung der unlöslichen Komponente bei. Dieser Zusammenhang kann in denjenigen Situationen gezielt ausgenützt werden, in denen keine ausreichenden Mengen Kühlwasser für die Durchführung des Verfahrens zur Verfügung stehen.

In Ausgestaltung dieses Verfahrens ist vorgesehen, dass die verschiedenen Werkstoffe der Gleitschicht, also namentlich das die Matrix bildende und das in der Matrix unlösliche Material, **gleichzeitig** mittels Kathodenzerstäubungsverfahren auf die Unterlage aufgebracht werden, wodurch die erfindungsgemässe Feinverteilung der unslöslichen Komponente zusätzlich verbessert wird. Dies kann vorzugsweise dadurch erreicht werden, dass mehr als die Hälfte der in dem Verfahren eingesetzten Targets sowohl den Hauptbestandteil der Matrix als auch den in der Matrix unlöslichen Werkstoff enthalten. Entsprechend der Zusammensetzung der gewünschten Gleitschicht kann es sich dabei namentlich um Legierungen mit folgender Zusammensetzung handeln: AlCuSn, AlCuPb, AlSiSn, AlSiPb, AlSiSnPb, CuSn, CuPb, CuSnPb.

In einer anderen Ausgestaltung des Verfahrens werden die verschiedenen Komponenten der Gleitschicht zeitlich nacheinander auf die Unterlage aufgebracht. Dazu werden vorteilhafterweise Targets aus den Hauptkomponenten der Gleitschicht, also beispielsweise aus Reinaluminium und Reinzinn, eingesetzt und an verschiedenen Positionen der betreffenden Beschichtungsvorrichtung aufgesputtert. Besonders vorteilhaft kann es dabei sein, für die Erzeugung der Diffusionssperrschicht und der Gleitschicht die gleichen Targets einzusetzen und die beiden unterschiedlichen Schichten unmittelbar nacheinander auf den zu beschichtenden Werkstücken zu bilden. In einer weiteren Variante des erfindungsgemässen Verfahrens wird die Temperatur des Substrats in dem Sinne variiert, dass die matrixbildende Komponente bei höherer Temperatur aufgebracht wird als die in der Matrix unlösliche Komponente. Dies kann in einer weiteren Variante derart geschehen, dass die matrixbildende Komponente der Gleitschicht bei höherer Substrattemperatur zeitlich vor der unlöslichen Komponente aufgebracht wird und die Temperatur während des Beschichtungsvorganges abgesenkt wird. Weitere Variationsmöglichkeiten des erfindungsgemässen Verfahrens ergeben sich dadurch, dass die Spannung, an die das zu beschichtende Substrat gelegt wird entsprechend den Gegebenheiten des konkreten Anwendungsfalles variiert wird. Dies kann vorteilhafterweise derart geschehen, dass die Komponenten mit den höheren Schmelzpunkten, also etwa die matrixbildende Komponente oder die Hauptkomponente der Diffusionssperrschicht, bei höherer Spannung aufgebracht werden als die in der Matrix unlösliche Komponente mit dem niedrigeren Schmelzpunkt.

Der für die Sauerstoffdotierung erforderliche Sauerstoff kann dabei entweder in der Form einer gasförmigen Substanz während des Kathodenzerstäubungsvorganges in das Plasmagas eingeleitet werden, oder in der Form von Oxiden der im matrixbildenden Werkstoff enthaltenen Elemente vor dem Kathodenzerstäubungsvorgang in das dabei eingesetzte Target oder einen Teil der dabei eingesetzten Targets eingebracht werden. Im ersten Fall kommen als gasförmige Substanzen in erster Linie elementarer Sauerstoff selbst oder Luft in Frage, doch können in besonders gelagerten Anwendungsfällen auch Sauerstoffverbindungen eines der folgenden Elemente oder von Kombinationen dieser Elemente eingesetzt werden: Wasserstoff, Kohlenstoff, Stickstoff. von diesen Sauerstoffverbindungen dürften Wasserdampf und $CO_2$ die grösste praktische Bedeutung für die hier diskutierte Sauerstoffdotierung haben. Üblicherweise wird bei dieser Variante derart verfahren, dass während dem Beschichtungsvorgang durch Kathodenzerstäuben in der Vakuumkammer der Vorrichtung ein Partialdruck des sauerstoffliefernden Gases von 1 bis 50% des Gesamtdruckes des Gasgemisches aufrechterhalten wird, wobei vorzugsweise Argon als weitere Komponente dieses Gemisches verwendet wird.

Nach einer zweiten Variante wird der für die gezielte Dosierung erforderliche Sauerstoff als Oxid in das bei der Kathodenzerstäubung verwendete Target oder einen Teil der verwendeten Targets eingelagert. Dadurch entsteht die Möglichkeit, den Grad der Sauerstoffdotierung der Gleitschicht über diesen Oxidgehalt des Targets oder über die elektrische Leistungsdichte desselben während der Kathodenzerstäubung zu steuern. Dies kann namentlich dadurch geschehen, dass das betreffende Target zur Einstellung der erforderlichen Sauerkonzentration vor dem Kathodenzerstäuben einer Kombination von Vakuum- und Wärmebehandlung in einer sauerstoffhaltigen Atmosphäre unterworfen wird. Eine Alternative dazu besteht im gezielten Zumischen von Oxidpulver, beispielsweise $Al_2O_3$, bei der Herstellung der Targets, sei dies in Stranggiessverfahren oder auf pulvermetallurgischem Wege durch Pressen und Sintern. Entsprechend den bevorzugten matrixbildenden Werkstoffen handelt es sich dabei in erster Linie um die Oxide der folgenden Elemente: Aluminium, Chrom, Nickel, Magnesium, Kupfer, Zinn, Indium, Blei, Zink.

Die erfindungsgemässen Verbundwerkstoffe können namentlich in Gleitlagern jeder Art erfolgreich eingesetzt werden. Die in derartigen Gleitlagern eingesetzten Lagerschalen werden mit den erfindungsgemässen Gleitschichten als Oberflächenschichten versehen derart, dass diese Gleitschicht am Scheitel der Lagerschale den geringsten mittleren Partikeldurchmesser der unlöslichen Komponente und damit die grösste Härte und im Bereich der Nahtstelle zur Schwesterhalbschale den grössten mittleren Partikeldurchmesser und damit die geringste Härte aufweist. Am Scheitel der Lagerschale muss dabei die Gleitschicht eine Härte von mehr als 100 HV 0.002 aufweisen, um die Flächenpressungen der Pleuel aufzunehmen. Erfindungsgemässe Gleitschichten können bei Lagerbelastungen zwischen 80 und 120 N/mm$^2$ und bei Temperaturen des Lagerrückens zwischen 150 und 200 ° C eingesetzt werden. Unter diesen Bedingungen zeigten die erfindungsgemässen Schichten im Dauerbelastungsversuch nach 720 Stunden keinen messbaren Verschleiss.

Verschiedene Ausführungsformen der Erfindung werden im folgenden anhand der Zeichnungen beispielhaft erläutert. Dabei zeigen

Figur 1 eine schematische Ansicht eines Formstückes aus dem erfindungsgemässen Verbundwerkstoff;

Figur 2 einen Querschnitt durch ein Radialgleitlager (Pleuellager) eines schnellaufenden Verbrennungsmotors mit Lagerschalen aus dem erfindungsgemässen Verbundwerkstoff.

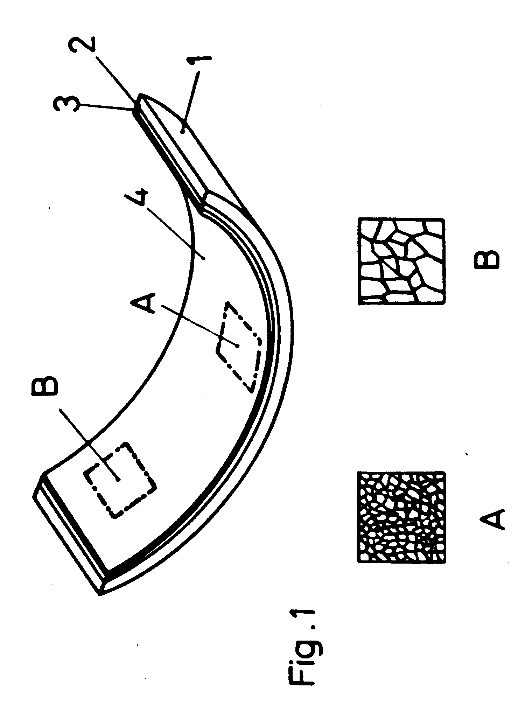

In der Ausführungsform der Figur 1 ist auf einem Stahlrükken (Grundwerkstoff) 1 eine Trägerschicht 2 aus einem Werkstoff mit guten Notlaufeigenschaften in einer Schichtdicke von 200 bis 700 $\mu$m aufgebracht. Wird für diese Trägerschicht 2 eine Blei- oder Bleizinnbronze verwendet, so erreicht diese Schicht eine Härte zwischen 50 und 100 HV 0.002. Auf diese Trägerschicht 2 ist eine dünne Diffusionssperrschicht 3 mit einer Schichtdicke von üblicherweise wenigen $\mu$m (2-4 $\mu$m) in Kathodenzerstäubungsverfahren aufgebracht. Diese Diffusionssperrschicht besteht aus einem oder mehreren Elementen des matrixbildenden Werkstoffes der Gleitschicht, beispielsweise Nickel, Chrom oder einer Legierung derselben. Auf diese Sperrschicht 3 ist die erfindungsgemässe Gleitschicht 4 durch Kathodenzerstäubung aufgebracht. Die auf Grund der Temperaturgradienten während des Kathodenzerstäubungsvorganges unterschiedliche Partikelgrösse der unlöslichen Komponente ist in den vergrösserten Einzelheiten A und B dargestellt, wobei der Auschnitt A einer feinverteilten Partie mit hoher Oberflächenhärte, der Ausschnitt B einer Partie mit grösserer mittlerer Partikelgrösse und entsprechend geringerer Oberflächenhärte entspricht. Dementsprechend verläuft in der Gleitschicht 4 eine Härtegradient vom Ausschnitt A zum Ausschnitt B.

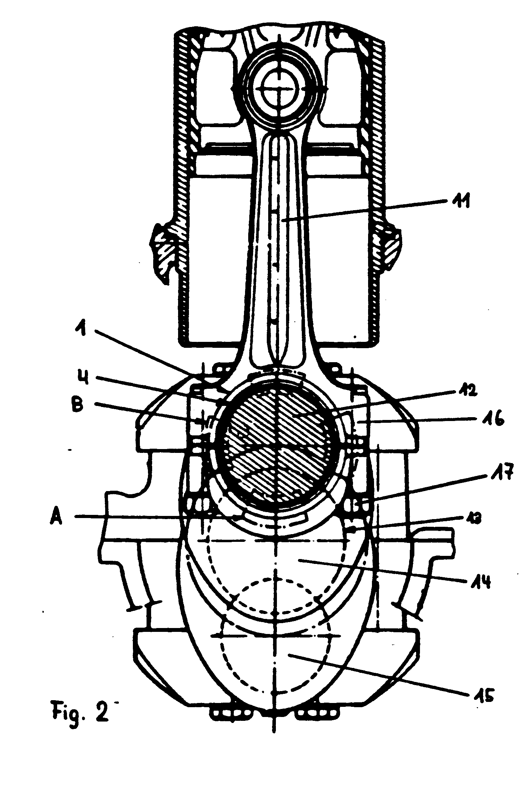

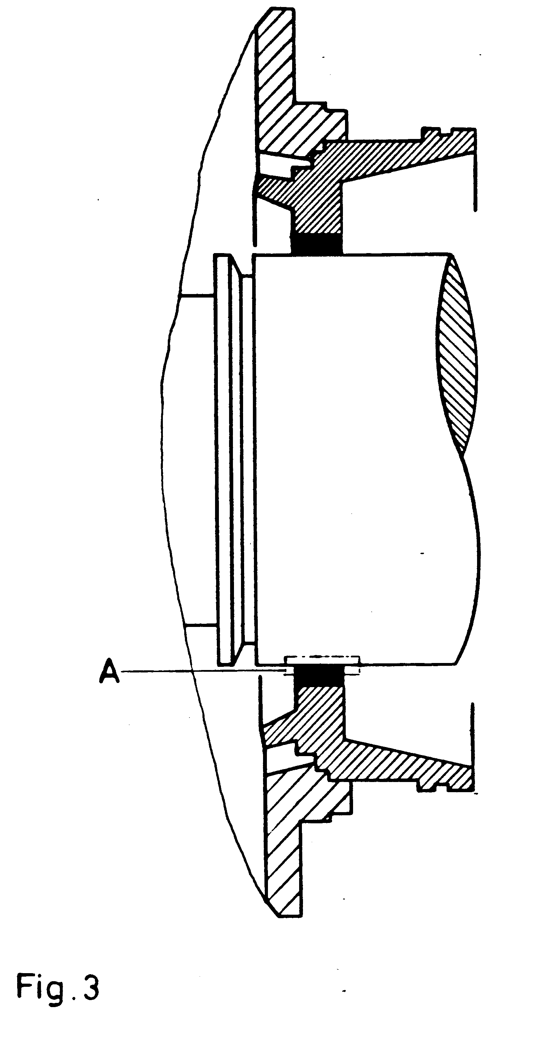

In Figur 2 ist die Verwendung der erfindungsgemässen Verbundwerkstoffe als Lagerschalen in einem Radialgleitlager (Pleullager) eines schnellaufenden Verbrennungsmotors dargestellt. Die Pleuelstange 11 setzt in dieser Anordnung ihre Bewegung in eine Drehbewegung einer Kurbelwelle um, welche aus Kurbelzapfen 12, Wellenzapfen 13 und zwei verschiedenen Kurbelwangen 14 und 15 besteht. Zwischen dem geteilten unteren Pleuelstangenkopf 16 und dem umlaufenden Kurbelzapfen 12 sind zwei halbzylinderförmige Lagerschalen aus dem erfindungsgemässen Verbundwerkstoff eingesetzt und die gute Zusammensetzung wird mit den Pleuelschrauben 17 fixiert. Die Gleitschicht 4 der Lagerschale steht dementsprechend im Kontakt mit dem Kurbelzapfen 12 und der Stahlrücken 1 ruht auf dem Pleuelstangenkopf 16.

In dieser Anordnung bedürfen die Auschnitte A am Scheitel der Lagerschalen einer hohen Tragfähigkeit, um die Flächenpressung der Pleuelstange aufzunehmen, und weisen deshalb eine feinere Verteilung der unlöslichen Phase wie in Figur 1 dargestellt auf. Demgegenüber wird von den Ausschnitten B am Uebergang zur Schwesterhalbschale ein gutes Einbettverhalten für Abrieb- und Schmutzpartikel gefordert, was durch eine entsprechend geringere Oberflächenhärte und gröbere Verteilung der unlöslichen Komponente erreicht werden kann. In beiden Lagerschalen bestehen demnach je zwei erfindungsgemässe Härtegradienten zwischen den Ausschnitten A und B.

Für die Erzeugung der erfindungsgemässen Verbundwerkstoffe wurden beispielsweise folgende Reaktionsbedingungen eingehalten:

Beispiel 1

Die Beschichtungen wurden in einer an sich bekannten Kathodenzerstäubungsvorrichtung durchgeführt, in welcher ein ringförmiges, dichtes Plasma mittels Magnetfeld unmittelbar vor der Kathode konzentriert wird. Die Anlage wies eine zylindrische Prozesskammer auf, an deren Aussenseite bis zu maximal vier Quellen von je 322.6 cm$^2$ Fläche vertikal montiert werden konnten. Die zu beschichtenden Substrate wurden ebenfalls vertikal auf einem Träger angebracht, der durch einen Drehantrieb rotiert werden konnte, der zwischen 0.2 und 24.5 Umdrehungen pro Minute regelbar war (vgl. beispielsweise BALZERS Produktinformationen BB 800 246 PD/August 1985 sowie BB 800 039 RD/Juli 1985).

Lagerschalen aus unlegiertem Werkzeugstahl (Stoff-Nr. 1.1625, Kurzbezeichnung (80W2) mit einer im Sinterverfahren aufgebrachten, 200 $\mu$m dikken Trägerschicht aus Bleibronze (CuPb 23Su4) wurden in dieser Zerstäubungsanlage bei einem Druck von 1.2 Pa in Argon in vollständiger Abwesenheit von Sauerstoff während 8 Stunden beschichtet. Durch eine separate Kühlleitung wurde dafür gesorgt, dass ausschliesslich der Scheitel (Abschnitt A in Figur 1) der Lagerschallen gekühlt wurde. Durch diese Massnahme stellte sich an dieser Stelle eine Substrattemperatur von 30 °C ein, während die Temperatur in Richtung des Abschnittes B der Lagerschale anstieg und an den beiden Enden der Lagerschale zwischen 170 und 190 °C betrug. Zur Aufrechterhaltung dieser Temperatur am Scheitel der Lagerschalen wurden

0.005 m$^3$ Kühlwasser (~10°C) pro Stunde und zu beschichtende Lagerschale benötigt.

Als Targets wurden einerseits Reinalumium (99.99) bei einer Spannung von 470 Volt, andererseits eine Zinnbronze der Zusammensetzung SnCu5 bei einer Spannung von 620 Volt eingesetzt und mit einer Leistungsdichte von 20 kW/322 Cm$^2$ bzw. von 10.3 kW/322 cm$^2$ gefahren. Bei einer Rotation der Substrate mit einer konstanten Umdrehungsgeschwindigkeit von 15 Umdrehungen pro Minute wurde dabei eine Beschichtungsgeschwindigkeit von rund 0.3 $\mu$m/Min. entsprechend einer Schichtdicke von rund 150 $\mu$m am Ende der Behandlung erreicht.

Die auf diese Weise erzeugte Schicht wies ein Gewichtsverhältnis von Al:Sn:Cu von 80:20:1 (entsprechend der Zusammensetzung AlSn20Cul) und einen Oxidgehalt von weniger als 0.2 Gewichtsprozenten auf. Sie wies am Lagerscheitel einen mittleren Partikeldurchmesser von rund 0.3 $\mu$m und an den Enden der Lagerschalen eine solche von rund 5 $\mu$m auf. Die Härte betrug 113 HV 0.002 am Lagerscheitel (Abschnitt A) und 45 HV 0.002 an den Enden der Lagerschalen (Abschnitt B). Diese Härte verminderte sich bei einer Auslagerung an der Luft bei 170 °C während 250 Stunden lediglich auf etwa 92 HV 0.002. Beim Test auf der Lagerprüfmaschine während 250 Stunden, einer Belastung von 70 N/mm$^2$ und einer Lagerrücktemperatur von T = 160 °C zeigten diese Schichten keinen messbaren Verschleiss.

Beispiel 2

Die Prozessbedingungen des Beispiels 1 wurden in dem Sinne variiert, dass zunächst während 1 1/2 Stunden nur die Targets aus einer AlSi-Legierung (Al + 0.1 - 2% Si) eingeschaltet wurden und die Lagerschalen auf eine einheitliche Temperatur von 120 °C gekühlt wurden. Anschliessend wurden die beiden anderen Targets aus der Zinnbronze zugeschaltet und die Kühlung derart eingestellt, dass sie am Scheitel der Lagerschalen auf 20 °C, an den Enden der Lagerschalen auf 80 °C abfiel. Die Beschichtung wurde im übrigen unter den Bedingungen des Beispiels 1 fortgesetzt.

Sie ergab eine Härte der Gleitschicht am Lagerscheitel (Abschnitt A) von 130 HV 0.02 eine solche von 45 HV 0.02 an den beiden Enden der Lagerschalen (Abschnitt B).

Beispiel 3

Die Prozessbedingungen des Beispiels 1 wurden derart abgewandelt, dass in der Prozesskammer der Kathodenzerstäubungsanlage ein Druck von 1.2 Pa im Argon aufrechterhalten wurde, dem 5.0 Volumenprozente Sauerstoff beigemischt wurde. Im Unterschied zu der nach Beispiel 1 erhaltenen Schicht wies die unter diesen Bedingungen erzeugte Schicht einen Sauerstoffgehalt von 1.89 Gewichtsprozenten auf. Dem entsprach eine Härte von 160 HV 0.002 am Lagerscheitel (Abschnitt A in Figur 1) und eine solche von 35 HV 0.002 an den Rändern der Schale (Abschnitt B in Figur 1). Das Verhalten der Schicht beim Test auf der Lagerprüfmaschine entsprach demjenigen der in Beispiel 1 erzeugten Gleitschicht.

Beispiel 5

Lagerschalen aus dem gleichen Werkzeugstahl (Stoff-Nr. 1.1625) mit einer im Tauchverfahren aufgebrachten, 200 um dicken Trägerschicht aus CuPb23Sn4 (Bleibronze) wurden in Abwesenheit von Sauerstoff im Plasmagas unter gleichen Bedingungen wie in Beispiel 1 beschichtet. Die Wassermenge betrug dabei 0.035 $m^3$ pro Stunde und zu beschichtende Lagerschale. Zum Aufbringen der Gleitschicht wurden folgende Targets und Leistungsdichten verwendet: ein Target Zinn (10.3 kW/322 $cm^2$), ein Target Blei (11 kW/322 $cm^2$) sowie 2 Targets AlSi mit wechselnden Konzentrationen von $Al_2O_3$ (1 - 5 Gewichtsprozente) und wechselnder elektrischer Leistungsdichte (20 - 120 kW/322 $cm^2$).

Daraus ergab sich eine Gleitschicht der ungefähren Zusammensetzung AlSi45Sn15 Pb10, deren Sauerstoffgehalt durch Variieren des Oxidgehaltes sowie der elektrischen Leistungsdichten des Targets während des Zerstäubungsprozesses eingestellt wurde. Bei Verwendung zweier Targets mit einer Oxidkonzentration von 5% $Al_2O_3$ ergab sich beispielsweise bei einer Leistungsdichte von 30 KW/322 $cm^2$ eine Endkonzentration von 0.7 Gewichtsprozenten Sauerstoff in der Schicht bei einer solchen von 80 KW/322 $cm^2$ eine Sauerstoffkonzentration von 1.3 Gewichtsprozenten. Diese Schichten wiesen am Scheitel der Lagerschalen einen mittleren Partikeldurchmesser von 0.2 $\mu m$ und an den Rändern derselben eine solche von 5 $\mu m$ auf. Ihre Härte betrug dementsprechend zwischen 165 HV 0.002 (Abschnitt A) und 50 HV 0.002 (Abschnitt B)

Beispiel 5

Die Prozessbedingungen der Beispiele 1 bis 4 können derart variiert werden, dass die Lagerschalen vor dem Aufbringen der Gleitschicht mit einer dünnen Diffusionssperrschicht (Figur 1: Position 3) versehen werden. Zu diesem Zweck werden während 12 Minuten und 30 °C nur die beiden Targets aus der AlSi-Legierung eingeschaltet (20 KW/322 $cm^2$). Die Schichtdicke der so erzeugten Diffusionssperrschicht betrug rund 2 $\mu m$. Anschliessend werden die anderen Targets zugeschaltet und die Beschichtung unter den gleichen Bedingungen wie in den Beispielen 1 bis 4 abgeschlossen.

## Patentansprüche

1.  Verbundwerkstoff mit mindestens einer durch Kathodenzerstäubung aufgebrachten Gleitschicht, welche aus einem Gemisch von in statistischer Verteilung aufgestäubten Teilchen aus

    - mindestens einem eine fest zusammengefügte Matrix bildenden metallischen Werkstoff
    - und mindestens einem weiteren, in festem Zustand in Matrixwerkstoff praktisch unlöslichen metallischen Werkstoff besteht,

    dadurch gekennzeichnet, dass

    (a) der Durchmesser der Partikel aus dem in der Matrix unlöslichen Werkstoff an vorbestimmten Stellen Gradienten aufweist,

    (b) welche parallel zur Oberfläche der Gleitschicht verlaufen und

    (c) denen Gradienten der Härte der Gleitschicht entsprechen.

2.  Verbundwerkstoff nach Patentanspruch 1, dadurch gekennzeichnet, dass der Mittelwert der statistischen Normalverteilung des Durchmessers der unlöslichen Partikel im Bereich der Gradienten Werte zwischen 0.05 $\mu m$ und 10 $\mu m$ annimmt.

3.  Verbundwerkstoff nach den Patentansprüchen 1 und 2, dadurch gekennzeichnet, dass der in der Matrix unlösliche Werkstoff als Hauptbestandteil mindestens eines der folgenden Elemente enthält: Zinn, Blei, Indium, Zink.

4.  Verbundwerkstoff nach den Patentansprüchen 1 bis 3, dadurch gekennzeichnet, dass der matrixbildende Werkstoff eine Legierung enthält, deren Hauptbestandteil mindestens eines der folgenden Elemente ist: Aluminium, Chrom, Nickel, Magnesium, Kupfer.

5.  Verbundwerkstoff nach den Patentansprüchen 1 bis 4, dadurch gekennzeichnet, dass der Durchmesser der Partikel aus dem unlöslichen Werkstoff an der Stelle der Gleitschicht mit der höchsten Härte eine statistische Normalverteilung mit einem Mittelwert von $\bar{x} \leq 0.8$ $\mu m$, vorzugsweise mit einem Mittelwert $\bar{x}$ zwischen 0.05 $\mu m$ und 0.4 $\mu m$ aufweist.

**6.** Verbundwerkstoff nach den Ansprüchen 1 bis 5,
dadurch gekennzeichnet, dass
der Sauerstoffgehalt der Gleitschicht unter 0.2 Gewichtsprozenten liegt.

**7.** Verbundwerkstoff nach den Ansprüchen 1 bis 6,
dadurch gekennzeichnet, dass
der Sauerstoffgehalt in der Gleitschicht zwischen 0.5 und 2.0 Gewichtsprozenten beträgt.

**8.** Verfahren zur Herstellung von Verbundwerkstoffen mit mindestens einer Gleitschicht, welche aus einem Gemisch von statistisch verteilten Teilchen aus mindestens einem eine fest zusammengefügte Matrix bildenden metallischen Werkstoff und mindestens einem weiteren, im Werkstoff der Matrix unlöslichen metallischen Werkstoff bestehen, nach dem Verfahren der Kathodenzerstäubung, dadurch gekennzeichnet, dass während dem Kathodenzerstäubungsvorgang im zu beschichtenden Substrat und in der aufwachsenden Gleitschicht Temperaturgradienten aufrechterhalten werden, welche parallel zur Oberfläche des Substrats verlaufen.

**9.** Verfahren nach Patentanspruch 8,
dadurch gekennzeichnet, dass
die Temperaturgradienten dadurch erzeugt werden, dass das zu beschichtende Substrat während des Kathodenzerstäubungsvorganges an unterschiedlichen Stellen unterschiedlich stark gekühlt wird, wobei die grösste Kühlleistung an denjenigen Stellen erbracht wird, an denen die Gleitschicht kleinsten Partikeldurchmesser und grösste Härte aufweisen soll.

**10.** Verfahren nach Patentanspruch 8 und 9,
dadurch gekennzeichnet, dass
die Temperatur des zu beschichtenden Substrats und der aufwachsenden Gleitschicht zwischen -10 und 190 °C gehalten wird.

**11.** Verfahren nach Patentanspruch 8 und 10,
dadurch gekennzeichnet, dass
die Temperatur des zu beschichtenden Substrats und der aufwachsenden Gleitschicht an den Stellen, an denen kleinster Partikeldurchmesser und grösste Härte der Gleitschicht angestrebt wird, zwischen -10 und 70 °C gehalten wird.

**12.** Verfahren nach den Ansprüchen 8 bis 11,
dadurch gekennzeichnet, dass
die verschiedenen Komponenten der Gleitschicht gleichzeitig aufgebracht werden.

**13.** Verfahren nach den Ansprüchen 8 bis 11,
dadurch gekennzeichnet, dass
die verschiedenen Komponenten der Gleitschicht zeitlich verschoben in die Gleitschicht eingebracht werden.

**14.** Verfahren nach den Ansprüchen 8 bis 11 und 13
dadurch gekennzeichnet, dass
die matrixbildende Komponente vor der unlöslichen Komponente aufgebracht wird und die Substrattemperatur während des Beschichtungsvorganges einheitlich abgesenkt wird.

**15.** Verfahren nach den Ansprüchen 8 bis 14,
dadurch gekennzeichnet, dass
der erforderliche Sauerstoff dem Plasma während der Kathodenzerstäubung in der Form einer gasförmigen Substanz zugeführt wird.

**16.** Verfahren nach den Ansprüchen 8 bis 14,
dadurch gekennzeichnet, dass
der erforderliche Sauerstoff als Oxid in das bei der Kathodenzerstäubung benutzte Target eingelagert wird.

**17.** Verwendung von Verbundwerkstoffen nach den Patentansprüchen 1 bis 7 in Gleitlagerschalen, insbesondere für dynamisch hochbeanspruchte Gleitlager, dadurch gekennzeichnet, dass
(a) die Gleitschicht am Scheitel der Lagerschale den geringsten mittleren Partikeldurchmesser der unlöslichen Komponente und damit die grösste Härte und
(b) die Gleitschicht im Bereich der Nahtstelle zur Schwesterhalbschale den grössten mittleren Partikeldurchmesser der unlöslichen Komponente und damit die geringste Härte aufweist.

**18.** Verwendung von Verbundwerkstoffen nach Patentanspruch 17,
dadurch gekennzeichnet, dass
die Gleitschicht am Scheitel der Lagerschale eine Härte von mehr als 60 HV 0.002 aufweist.

**Claims**

**1.** A composite material having at least one sliding layer which is applied by cathodic sputtering and which comprises a mixture of particles sputtered in a statistical distribution and comprising:
- at least one metallic material forming a fixedly united matrix, and
- at least one further metallic material which is practically insoluble in a solid state in the matrix material,

characterised in that

(a) the diameter of the particles of the material which is insoluble in the matrix has at predetermined locations gradients
(b) which extend parallel to the surface of the sliding layer and
(c) to which there correspond gradients in respect of the hardness of the sliding layer.

2. A composite material according to claim 1 characterized in that the mean value of the statistical normal distribution of the diameter of the insoluble particles in the region of the gradients assumes values between 0.05 $\mu$m and 10 $\mu$m.

3. A composite material according to claims 1 and 2 characterized in that the material which is insoluble in the matrix contains as its main constituent at least one of the following elements: tin, lead, indium and zinc.

4. A composite material according to claims 1 to 3 characterized in that the matrix-forming material contains an alloy, the main constituent of which is at least one of the following elements: aluminium, chromium, nickel, magnesium and copper.

5. A composite material according to claims 1 to 4 characterized in that the diameter of the particles of the insoluble material, at the location of the sliding layer of the greatest hardness, has a statistical normal distribution with a mean value of $\overline{x} \leq 0.8$ $\mu$m, preferably with a mean value $\overline{x}$ of between 0.05 $\mu$m and 0.4 $\mu$m.

6. A composite material according to claims 1 to 5 characterized in that the oxygen content of the sliding layer is below 0.2 percent by weight.

7. A composite material according to claims 1 to 6 characterized in that the oxygen content in the sliding layer is between 0.5 and 2.0 percent by weight.

8. A process for the production of composite materials having at least one sliding layer, which comprise a mixture of statistically distributed particles of at least one metallic material forming a fixedly united matrix, and at least one further metallic material which is insoluble in the material of the matrix, in accordance with the cathodic sputtering method, characterized in that during the cathodic sputtering operation temperature gradients which extend parallel to the surface of the substrate are maintained in the substrate to be coated and in the growing sliding layer.

9. A process according to claim 8 characterized in that the temperature gradients are produced by the substrate to be coated being cooled to different degrees at different locations during the cathodic sputtering operation, the greatest cooling effect being produced at those locations at which the sliding layer is to be of smallest particle diameters and of greatest hardness.

10. A process according to claim 8 and claim 9 characterized in that the temperature of the substrate to be coated and the sliding layer growing thereon is kept between -10 and 190°C.

11. A process according to claim 8 and claim 10 characterized in that the temperature of the substrate to be coated and the sliding layer growing thereon is kept at between -10 and 70°C at the locations at which the aim is to produce the smallest particle diameter and the greatest hardness in the sliding layer.

12. A process according to claims 8 to 11 characterized in that the various components of the sliding layer are applied simultaneously.

13. A process according to claims 8 to 11 characterized in that the various components of the sliding layer are introduced into the sliding layer in time-shifted relationship.

14. A process according to claims 8 to 11 and 13 characterized in that the matrix-forming component is applied prior to the insoluble component and the substrate temperature is uniformly reduced during the coating operation.

15. A process according to claims 8 to 14 characterized in that the necessary oxygen is fed to the plasma during the cathodic sputtering operation in the form of a gaseous substance.

16. A process according to claims 8 to 14 characterized in that the necessary oxygen is incorporated in the form of oxide into the target used in the cathodic sputtering operation.

17. Use of composite materials according to claims 1 to 7 in sliding bearing shells, in particular for dynamically highly loaded sliding bearings, characterized in that

(a) the sliding layer has the smallest mean particle diameter in respect of the insoluble component and thus the greatest hardness at the apex of the bearing shell, and
(b) the sliding layer has the greatest mean particle diameter in respect of the insoluble component and thus the lowest level of hardness in the region of the junction with the sister half-shell.

18. Use of composite materials according to claim 17 characterized in that the sliding layer at the apex of the bearing shell has a hardness of more than 60 HV 0.002.

**Revendications**

1. Matériau composite comportant au moins une couche de glissement appliquée par pulvérisation cathodique, et composé d'un mélange de particules qui sont réparties, à l'état pulvérulent, suivant une distribution statistique et qui sont formées
   - d'au moins un matériau métallique définissant une matrice à forte cohésion
   - et d'au moins un second matériau métallique pratiquement insoluble dans le matériau-matrice, à l'état solide,
   caractérisé en ce que
   (a) le diamètre des particules du matériau insoluble dans la matrice présente, à des endroits prédéfinis, des gradients
   (b) qui s'étendent parallèlement à la surface de la couche de glissement et
   (c) auxquels correspondent des gradients de la dureté de la couche de glissement.

2. Matériau composite selon la revendication 1, caractérisé en ce que la valeur moyenne de la distribution normale statistique du diamètre des particules insolubles est de 0,05 $\mu$m à 10 $\mu$m dans la zone des gradients.

3. Matériau composite selon les revendications 1 et 2, caractérisé en ce que le matériau insoluble dans la matrice contient, comme élément principal, l'un au moins des éléments suivants : étain, plomb, indium, zinc.

4. Matériau composite selon les revendications 1 à 3, caractérisé en ce que le matériau formant la matrice contient un alliage dont l'élément principal est l'un au moins des éléments suivants : aluminium, chrome, nickel, magnésium, cuivre.

5. Matériau composite selon les revendications 1 à 4, caractérisé en ce que le diamètre des particules du matériau insoluble présente, à l'endroit de la couche de glissement la plus dure, une distribution normale statistique d'une valeur moyenne de $\overline{x} \leq 0.8$ $\mu$m, de préférence d'une valeur moyenne $\overline{x}$ allant de 0.05 $\mu$m à 0.4 $\mu$m.

6. Matériau composite selon les revendications 1 à 5, caractérisé en ce que la teneur en oxygène de la couche de glissement est inférieure à 0.2 % en poids.

7. Matériau composite selon les revendications 1 à 6, caractérisé en ce que la teneur en oxygène dans la couche de glissement est de 0.5 à 2.0 % en poids.

8. Procédé pour la fabrication de matériaux composites comportant au moins une couche de glissement et composés d'un mélange de particules qui sont réparties statistiquement et qui sont formées d'au moins un matériau métallique définissant une matrice à forte cohésion et d'au moins un second matériau métallique insoluble dans le matériau de la matrice, suivant le procédé de pulvérisation cathodique, caractérisé en ce que, pendant l'opération de pulvérisation cathodique, on maintient dans le substrat à recouvrir et dans la couche de glissement se formant des gradients de température qui s'étendent parallèlement à la surface du substrat.

9. Procédé selon la revendication 8, caractérisé en ce que les gradients de température sont obtenus grâce au fait que le substrat à recouvrir est refroidi plus ou moins fortement à différents endroits, pendant l'opération de pulvérisation cathodique, le pouvoir refroidisseur étant le plus élevé aux endroits où la couche de glissement doit présenter le diamètre de particules le plus petit et la dureté la plus élevée.

10. Procédé selon les revendications 8 et 9, caractérisé en ce que la température du substrat à recouvrir et de la couche de glissement se formant est maintenue entre -10 et 190°C.

11. Procédé selon les revendications 8 et 10, caractérisé en ce que la température du substrat à recouvrir et de la couche de glissement se formant est maintenue entre -10 et 70°C aux endroits où on souhaite le diamètre de particules le plus petit et la dureté de couche de glissement la plus élevée.

12. Procédé selon les revendications 8 à 11, caractérisé en ce que les différents composants de la couche de glissement sont appliqués simultanément.

13. Procédé selon les revendications 8 à 11, caractérisé en ce que les différents composants de la couche de glissement sont insérés dans celle-ci façon décalée dans le temps.

14. Procédé selon les revendications 8 à 11 et 13, caractérisé en ce que le composant formant la matrice est appliqué avant le composant insoluble et la température du substrat est abaissée uniformément pendant l'opération de recouvrement.

15. Procédé selon les revendications 8 à 14, caractérisé en ce que l'oxygène nécessaire est amené vers le plasma, pendant la pulvérisation cathodique, sous la forme d'une substance gazeuse.

16. Procédé selon les revendications 8 à 14, caractérisé en ce que l'oxygène nécessaire est incorporé sous forme d'oxyde dans la cible utilisée lors de la pulvérisation cathodique.

17. Utilisation de matériaux composites selon les revendications 1 à 7 dans des coussinets, notamment pour des paliers lisses soumis à de fortes sollicitations dynamiques, caractérisée en ce que
   (a) la couche de glissement présente, au niveau du sommet de la coquille de coussinet, le diamètre de particules moyen le plus petit pour le composant insoluble et, de ce fait, la dureté la plus élevée, et
   (b) la couche de glissement présente, dans la zone de jonction avec la demi-coquille associée, le diamètre de particules moyen le plus grand pour le composant insoluble et, de ce fait, la dureté la plus faible.

18. Utilisation de matériaux composites selon la revendication 17, caractérisée en ce que la couche de glissement présente, au niveau du sommet de la coquille de coussinet, une dureté supérieure à 60 HV 0.002.

Fig.1

Fig. 2

Fig. 3